# EUROPÄISCHE PATENTSCHRIFT

(11) **EP 3 401 652 B1**
(45) Veröffentlichungstag und Bekanntmachung des Hinweises auf die Patenterteilung: **12.08.2020**
(21) Anmeldenummer: 17170104.8
(22) Anmeldetag: 09.05.2017
(51) Int. Cl.: G01S 7/03, G01S 7/35, H03L 7/08, G01F 23/284, G01F 23/296, G01S 13/34

(54) **RADARFÜLLSTANDMESSGERÄT MIT EINEM PHASENREGELKREIS**
RADAR FILL LEVEL MEASUREMENT DEVICE COMPRISING A PHASE-LOCKED LOOP
JAUGE RADAR ÉQUIPÉE D'UNE BOUCLE À VERROUILLAGE DE PHASE

(43) Veröffentlichungstag der Anmeldung: 14.11.2018
(73) Patentinhaber: VEGA Grieshaber KG, 77709 Wolfach (DE)
(72) Erfinder: SCHULTHEISS, Daniel, 78132 Hornberg (DE); MÜLLER, Christoph, 77728 Oppenau (DE)
(74) Vertreter: Maiwald Patent- und Rechtsanwaltsgesellschaft mbH

(56) Entgegenhaltungen:
- EP-A1- 2 166 319
- EP-A1- 3 059 559
- EP-A2- 0 945 715
- WO-A1-2015/059260
- DE-A1- 19 531 540

## Beschreibung

### Gebiet der Erfindung

Die Erfindung betrifft allgemein das Gebiet der radarbasierten Füllstandmessung. Insbesondere betrifft die Erfindung ein Radarfüllstandmessgerät mit einem Phasenregelkreis zur Bestimmung eines Füllstandes eines Mediums, die Verwendung eines solchen Radarfüllstandmessgeräts zur Bestimmung eines Füllstandes eines Mediums sowie ein Verfahren zum Betreiben eines solchen Radarfüllstandmessgerätes.

### Technischer Hintergrund der Erfindung

Radarbasierte Füllstandmessgeräte und/oder Radarfüllstandmessgeräte weisen in der Regel ein Radarmodul zur Erzeugung eines Sendesignals, insbesondere eines hochfrequenten Radarsendesignals, auf.

Allgemein wird bei Radarfüllstandmessgeräten das Sendesignal an eine Oberfläche eines Mediums abgestrahlt, wobei ein Teil des Sendesignals an der Oberfläche reflektiert wird und wiederum von dem Radarfüllstandmessgerät als Empfangssignal empfangen wird. Basierend auf einem Laufzeitverfahren kann so die Entfernung des Radarfüllstandmessgeräts zur Oberfläche des Mediums und/oder der Füllstand des Mediums ermittelt werden.

Dabei kann das Sendesignal während eines Messzyklus beispielsweise als Dauerstrichsignal an die Oberfläche des Mediums ausgesendet werden. Derartige Füllstandmessgeräte werden häufig auch als Dauerstrich-Radarfüllstandmessgeräte bzw. als "Continuous-Wave (CW)" Füllstandmessgeräte bezeichnet. Auch kann das Sendesignal während eines Messzyklus stufenförmig in seiner Frequenz angehoben werden, wobei derartige Radarfüllstandmessgeräte häufig SFCW-Füllstandmessgeräte ("Stepped-Frequency-Continuous-Wave, SFCW") genannt werden. Des Weiteren wird häufig die Frequenz des Sendesignals während eines Messzyklus kontinuierlich und linear angehoben. Derartige Radarfüllstandmessgeräte werden allgemein FMCW-Füllstandmessgeräte ("Frequency-Modulated-Continuous-Wave, FMCW") genannt.

Zur Realisierung der voranstehend genannten Radarfüllstandmessgeräte, insbesondere zur Realisierung der entsprechenden Radarmodule dieser Radarfüllstandmessgeräte, können mitunter komplexe elektronische Schaltungen erforderlich sein.

EP 0 945 715 A2 beschreibt ein Füllstandmessgerät, welches zur Generierung eines Radarsignals einen Frequenzvervielfacher einsetzt.

WO 2015/059260 A1 beschreibt ein Radar-Füllstandmessgerät und ein Verfahren zur Messung eines Abstandes zu einer Oberfläche eines Produktes in einem Behälter.

### Zusammenfassung der Erfindung

Es ist eine Aufgabe der Erfindung, ein verbessertes Radarfüllstandmessgerät anzugeben, welches sich insbesondere durch einen vereinfachten Aufbau bei gleichzeitig hoher Robustheit und Zuverlässigkeit auszeichnen kann.

Diese Aufgabe wird durch die Merkmale der unabhängigen Ansprüche gelöst. Weiterbildungen der Erfindung ergeben sich aus den Unteransprüchen sowie der nachfolgenden Beschreibung.

Ein Aspekt der Erfindung betrifft ein Radarfüllstandmessgerät zur Bestimmung und/oder Ermittlung eines Füllstandes eines Mediums und/oder ein radarbasiertes Füllstandmessgerät zur Bestimmung und/oder Ermittlung eines Füllstandes eines Mediums. Das Radarfüllstandmessgerät weist ein Radarmodul zur Erzeugung eines Sendesignals, insbesondere eines Radarsendesignals, mit einer Sendefrequenz von wenigstens 60 GHz auf. Mit anderen Worten kann es sich bei dem Sendesignal um ein hochfrequentes Sendesignal mit einer Frequenz bzw. einer Sendefrequenz von wenigstens 60 GHz handeln. Weiter weist das Radarfüllstandmessgerät wenigstens eine mit dem Radarmodul gekoppelte Antenne, wie etwa eine Hornantenne und/oder eine Parabolantenne, zum Aussenden des Sendesignals an eine Oberfläche eines Mediums und zum Empfangen eines an der Oberfläche reflektierten Empfangssignals, insbesondere eines Radarempfangssignals, auf. Das Radarmodul weist einen Phasenregelkreis auf. Der Phasenregelkreis weist wiederum einen Oszillator zur Ausgabe eines Ausgangssignals an einem Ausgang des Oszillators, einen mit dem Ausgang des Oszillators gekoppelten Phasendetektor und einen zwischen den Ausgang des Oszillators und einen Eingang des Phasendetektors gekoppelten Frequenzteiler zum Erzeugen eines frequenzgeteilten Signals basierend auf dem Ausgangssignal des Oszillators auf. Ferner weist das Radarmodul eine zwischen den Oszillator und die Antenne gekoppelte Sende-Empfangsweiche zur Trennung des Sendesignals und des Empfangssignals auf. Dabei ist der Ausgang des Oszillators direkt und/oder unmittelbar mit einem Eingang der Sende-Empfangsweiche verschaltet, so dass basierend auf dem Ausgangssignal des Oszillators das Sendesignal über die Antenne abgestrahlt werden kann. Mit anderen Worten kann der Ausgang des Oszillators direkt und/oder unmittelbar mit dem Eingang der Sende-Empfangsweiche gekoppelt und/oder verbunden sein, wobei ein Ausgang der Sende-Empfangsweiche mit der Antenne gekoppelt sein kann, so dass basierend auf dem Ausgangssignal des Oszillators das Sendesignal über die Antenne abgestrahlt werden kann. Dabei sind der Frequenzteiler und die Sende-Empfangsweiche mit demselben Ausgang des Oszillators gekoppelt und/oder der Frequenzteiler ist an denselben Ausgang des Oszillators angeschlossen wie die Sende-Empfangsweiche. Der Phasendetektor weist ferner einen Referenzeingang zum Empfangen eines Referenzfrequenzsignals und einen Phasendetektorausgang auf, welcher mit einem Steuereingang des Oszillators gekoppelt ist. Dabei ist der Phasendetektor dazu ausgeführt, einen Phasenunterschied zwischen dem Referenzfrequenzsignal und dem basierend auf dem Ausgangssignal des Oszillators erzeugten frequenzgeteilten Signal, welches von dem Frequenzteiler bereitgestellt sein kann, zu ermitteln und/oder zu bestimmen und an dem Phasendetektorausgang ein mit dem ermittelten Phasenunterschied korrelierendes Regelsignal zur Regelung der Ausgangsfrequenz des Ausgangssignals des Oszillators an den Steuereingang des Oszillators auszugeben. Durch Regelung der Ausgangsfrequenz des Ausgangssignals kann so die Sendefrequenz des Sendesignals geregelt werden.

Der Phasenregelkreis, auch PLL ("Phase-Locked-Loop") genannt, kann somit einen "Feedback-Regelkreis" bezeichnen, mit Hilfe dessen die Ausgangsfrequenz des Ausgangssignals des Oszillators und somit die Sendefrequenz des Sendesignals während eines Messzyklus geregelt werden kann. Dazu kann mit dem Phasendetektor, welcher häufig auch als Phasenvergleicher und/oder als PhasenKomparator bezeichnet wird, eine Phasendifferenz zwischen dem Ausgangssignal bzw. dem frequenzgeteilten Signal und dem Referenzfrequenzsignal ermittelt und/oder bestimmt werden. Wird eine derartige Phasendifferenz von dem Phasendetektor ermittelt, so kann dieser das Regelsignal an den Steuereingang des Oszillators ausgeben, um die Ausgangsfrequenz des Oszillators und damit die Sendefrequenz des Sendesignals zu regeln, beispielsweise auf einen vorbestimmten Sollwert bzw. eine Sollfrequenz. Gleichsam kann mit Hilfe des Phasendetektors eine Abweichung der Ausgangsfrequenz des Ausgangssignals und/oder der Sendefrequenz des Sendesignals von dem Sollwert ermittelt sowie durch das Regelsignal kompensiert werden. Damit kann in vorteilhafter Weise die Ausgangsfrequenz und/oder die Sendefrequenz zuverlässig geregelt werden.

Das Medium kann allgemein eine Flüssigkeit und/oder ein Fluid in einem Behälter sein. Alternativ oder zusätzlich kann das Medium ein Schüttgut in einem Behälter und/oder in einer Lagerstätte, wie etwa einer Schüttguthalde, sein. Weiter kann das Medium auch ein fluides Medium, wie etwa ein Gerinne, bezeichnen und das erfindungsgemäße Radarfüllstandmessgerät kann gleichsam für eine Gerinnemessung eingesetzt werden.

Erfindungsgemäß ist insbesondere vorgehsehen, den Ausgang des Oszillators direkt und/oder unmittelbar mit dem Eingang der Sende-Empfangsweiche zu verschalten, zu verbinden und/oder zu koppeln. Mit anderen Worten kann der Ausgang des Oszillators direkt mit dem Eingang des Sende-Empfangsweiche verbunden sein, ohne dass dazwischen weitere Elektronikkomponenten gekoppelt und/oder angeordnet sind. Beispielsweise ist bei bekannten Radarfüllstandmessgeräten häufig zwischen den Ausgang des Oszillators und den Eingang der Sende-Empfangsweiche ein Frequenzvervielfacher zur Vervielfachung der Ausgangsfrequenz des Oszillators gekoppelt. Ein derartiger Frequenzvervielfacher entfällt bei dem erfindungsgemäßen Radarfüllstandmessgerät. Durch Vermeidung des Frequenzvervielfachers kann in vorteilhafter Weise eine Leistungsaufnahme bzw. ein Stromverbrauch des Radarmoduls und/oder des Radarfüllstandmessgeräts reduziert sein. Zudem kann Bauraum eingespart und/oder eine Baugröße des Radarmoduls reduziert werden. Mit anderen Worten kann ein Aufbau des Radarfüllstandmessgeräts vereinfacht sein, so dass insgesamt das Radarfüllstandmessgerät ohne Funktionseinbußen kompakt ausgebildet sein kann. Der vereinfachte und kompakte Aufbau des Radarfüllstandmessgeräts und/oder des Radarmoduls kann insbesondere bei Ausgestaltung des Radarmoduls in einem integrierten Radar-Chip, wie etwa einem Hochfrequenz-Chip und/oder einem Mikrowellen-Chip, vorteilhaft sein. Ein weiterer Vorteil des erfindungsgemäßen Radarfüllstandmessgeräts ist in Bezug auf ein Phasenrauschen des Oszillators zu sehen, wobei unter Phasenrauschen allgemein eine Schwankung der Phase des Ausgangssignals um eine Sollfrequenz zu verstehen sein kann. Bei Verwendung eines Frequenzvervielfachers zwischen Oszillator und Sende-Empfangsweiche wird dieses Phasenrauschen ebenso vervielfacht, was bei der erfindungsgemäßen Ausgestaltung des Radarfüllstandmessgerätes entfällt.

Gemäß einer Ausführungsform ist der Oszillator ein Grundwellenoszillator, wobei der Oszillator dazu ausgeführt ist, an dem direkt mit dem Eingang der Sende-Empfangsweiche verschalteten Ausgang des Oszillators eine Grundfrequenz des Oszillators auszugeben. Mit anderen Worten kann der Oszillator als Grundwellenoszillator ausgeführt sein und an dem direkt mit dem Eingang der Sende-Empfangsweiche gekoppelten Ausgang des Oszillators kann das Ausgangssignal mit der Grundfrequenz des Oszillators ausgekoppelt werden, d.h. die Ausgangsfrequenz kann der Grundfrequenz entsprechen. Der Oszillator kann beispielsweise über eine verstärkende Einheit und einen Resonator, insbesondere einen Resonator hoher Güte, verfügen. Der Resonator kann zudem über wenigstens eine Varaktordiode in der Frequenz veränderbar sein. Derartige Oszillatoren werden auch spannungsgesteuerte Oszillatoren ("Voltage Controlled-Oscillator, VCO") genannt. Der Begriff "Grundwellenoszillator" kann daher im Sinne der vorliegenden Offenbarung einen Oszillator bezeichnen, welche mit der Resonanzfrequenz des zugehörigen Resonators des Oszillators schwingt und an dessen Ausgang das Ausgangssignal mit der Resonanzfrequenz abgegriffen werden kann. Gleichsam kann die "Grundfrequenz" des Oszillators die Resonanzfrequenz des zugehörigen Resonators des Oszillators bezeichnen.

Gemäß einer Ausführungsform ist der Oszillator ein Push-Push-Oszillator. Alternativ oder zusätzlich ist der Ausgang des Oszillators ein Hochfrequenzausgang des Oszillators. Der Oszillator kann etwa dazu ausgeführt sein, an dem direkt mit dem Eingang der Sende-Empfangsweiche verschalteten Ausgang des Oszillators eine erste Oberwelle auszugeben. Alternativ oder zusätzlich kann der Oszillator dazu ausgeführt sein, an dem direkt mit dem Eingang der Sende-Empfangsweiche verschalteten Ausgang des Oszillators ein Ausgangssignal mit einer doppelten Frequenz einer Grundfrequenz des Oszillators auszugeben.

Allgemein können Push-Push-Oszillatoren als differentielle Oszillatoren ausgeführt sein. Zudem können Push-Push-Oszillatoren über wenigstens eine Varaktordiode in ihrer Frequenz steuerbar und/oder regelbar ausgeführt werden. Häufig bestehen Push-Push-Oszillatoren aus wenigstens zwei Suboszillatoren, deren jeweilige Ausgangssignale ein Frequenzkamm sein kann. Die Ausgangssignale der Suboszillatoren können etwa über einen Koppler zusammengeführt werden, wobei die Ausgangssignale der Suboszillatoren zueinander etwa um 180° phasenverschoben sein können, so dass die ungeraden Vielfachen der Ausgangssignale der Suboszillatoren destruktiv interferieren können und dabei ausgelöscht werden können. Die geraden Vielfachen der Ausgangssignale der Suboszillatoren können dagegen konstruktiv interferieren, so dass harmonische Oberwellen entstehen können. Baubedingt kann ein Push-Push-Oszillator daher neben der Grundwelle des Oszillators auch geradzahlige Vielfache und/oder Oberwellen erzeugen, welche als Ausgangssignal des Push-Push-Oszillators abgegriffen werden können. Dabei werden die Oberwellen häufig an dem Hochfrequenzausgang des Push-Push-Oszillators abgegriffen und/oder ausgegeben, wobei der Push-Push-Oszillator einen weiteren Ausgang zur Auskopplung der Grundfrequenz des Oszillators aufweisen kann. Erfindungsgemäß kann daher vorgesehen sein, eine der Oberwellen des Push-Push-Oszillators an dem Hochfrequenzausgang abzugreifen und der Sende-Empfangsweiche zuzuführen, so dass auf einen Frequenzvervielfacher zwischen Oszillator und Sende-Empfangsweiche verzichtet werden kann. Ferner kann ein Push-Push-Oszillator in seiner Baugröße gegenüber herkömmlichen Oszillatoren reduziert sein, so dass die Baugröße des Radarmoduls durch Verwendung des Push-Push-Oszillators weiter reduziert sein kann.

Gemäß einer Ausführungsform ist das Radarmodul als V-Band-Radarmodul, als E-Band-Radarmodul, als W-Band-Radarmodul, als F-Band-Radarmodul, als D-Band-Radarmodul, als G-Band-Radarmodul, als Y-Band-Radarmodul und/oder als J-Band-Radarmodul ausgeführt. Mit anderen Worten kann die Sendefrequenz des Sendesignals zwischen 60 GHz und 75 GHz (V-Band), zwischen 60 GHz und 90 GHz (E-Band), zwischen 75 GHz und 110 GHz (W-Band), zwischen 90 GHz und 140 GHz (F-Band), zwischen 110 GHz und 170 GHz (D-Band), zwischen 140 GHz und 220 GHz (G-Band), zwischen 170 GHz und 260 GHz (Y-Band), und/oder zwischen 220 GHz und 320 GHz (J-Band) liegen.

Gemäß einer Ausführungsform weist der Phasenregelkreis ferner ein zwischen den Phasendetektorausgang des Phasendetektors und den Steuereingang des Oszillators gekoppeltes Schleifenfilter zur Filterung des Regelsignals des Phasendetektors auf. Beispielsweise kann das von dem Phasendetektor an dem Phasendetektorausgang ausgegebene Regelsignal ein mit dem ermittelten Phasenunterschied korrelierendes Puls-Paket sein, welches mit Hilfe des Schleifenfilters in ein gefiltertes Regelsignal überführt werden kann, welches von dem Oszillator zur Regelung der Ausgangsfrequenz des Oszillators verarbeitet werden kann.

Gemäß einer Ausführungsform weist das Radarfüllstandmessgerät und/oder das Radarmodul weiter einen mit der Sende-Empfangsweiche gekoppelten Frequenzmischer zur Erzeugung eines Zwischenfrequenzsignals basierend auf dem Sendesignal und basierend auf dem Empfangssignal auf. Das Zwischenfrequenzsignal kann dabei ein Differenzsignal bezeichnen, d.h. das Zwischenfrequenzsignal kann eine Frequenz aufweisen, welche im Wesentlichen der Differenz der Frequenzen des Sendesignals und des Empfangssignals entsprechen kann. Das Zwischenfrequenzsignal kann somit ein niederfrequentes Signal bezeichnen, welches mit weiteren Komponenten des Radarfüllstandmessgerätes zur Bestimmung des Füllstandes verarbeitet und/oder ausgewertet werden kann. Mit anderen Worten kann das Empfangssignal in dem Frequenzmischer mit dem unverzögerten Sendesignal in den Zwischenfrequenz-Bereich heruntergemischt werden und aus diesem Zwischenfrequenzsignal kann anschließend eine Entfernungsinformation bezüglich der Entfernung zwischen dem Radarfüllstandmessgerät und der Oberfläche, insbesondere basierend auf einer Fourier-Transformation des Zwischenfrequenzsignals und/oder basierend auf einer Frequenzbestimmung, ermittelt werden.

Gemäß einer Ausführungsform weist das Radarfüllstandmessgerät weiter eine digitale Steuereinheit zur Steuerung des Phasenregelkreises und/oder zur Steuerung des Phasendetektors mit digitalen Steuersignalen auf. Die Steuereinheit kann etwa als digitaler Signalprozessor ("Digital Signal Processor, DSP") und/oder als Mikrokontroller ausgeführt sein. Allgemein kann die Steuereinheit eine Logikvorrichtung des Radarfüllstandmessgerätes bezeichnen. Je nach Ansteuerung des Phasenregelkreises mit den digitalen Steuersignalen kann mit dem Radarmodul während eines Messzyklus eine lineare, kontinuierliche Frequenzrampe ("Frequency-Modulated-Continuous-Wave, FMCW"), eine gestufte Frequenzrampe ("Stepped-Frequency-Continuous-Wave") oder ein Dauerstrich-Signal ("Continuous-Wave-Signal, CW-Signal") erzeugt werden.

Gemäß einer Ausführungsform ist die digitale Steuereinheit dazu eingerichtet, den Phasenregelkreis derart anzusteuern, dass das Sendesignal während eines Messzyklus eine kontinuierlich-lineare Frequenzrampe durchläuft. Alternativ oder zusätzlich ist das Radarfüllstandmessgerät als Frequency-Modulated-Continuous-Wave (FMCW) Radar ausgeführt. Bei der kontinuierlich-linearen Frequenzrampe wird die Frequenz des Sendesignals während eines Messzyklus ausgehend von einer Grundfrequenz kontinuierlich und linear auf eine Maximalfrequenz angehoben und anschließend wieder auf die Grundfrequenz abgesenkt, so dass zuverlässig eine Entfernung des Radarfüllstandmessgeräts zur Oberfläche des Mediums und damit der Füllstand ermittelt werden kann. Alternativ oder zusätzlich ist die digitale Steuereinheit dazu eingerichtet, den Phasenregelkreis derart anzusteuern, dass das Sendesignal während eines Messzyklus eine gestufte Frequenzrampe durchläuft. Mit anderen Worten kann das Radarfüllstandmessgerät als SFCW-Radar ausgeführt sein, wobei die Frequenz des Sendesignals während eines Messzyklus ausgehend von einer Grundfrequenz stufenförmig über mehrere Stufen auf die Maximalfrequenz angehoben und anschließend wieder abgesenkt werden kann.

Gemäß einer Ausführungsform ist die digitale Steuereinheit ferner dazu eingerichtet, basierend auf einem von einem Frequenzmischer des Radarfüllstandmessgeräts ausgegebenen Zwischenfrequenzsignal eine Entfernung zu der Oberfläche des Mediums und/oder einen Füllstand des Mediums zu ermitteln. Beispielsweise kann die Steuereinheit dazu eingerichtet sein, ein mit dem Zwischenfrequenzsignal korrelierendes Messsignal, welches etwa durch einen Analog-Digital-Wandler bereitgestellt sein kann, im Rahmen einer Fourier-Analyse, insbesondere einer Fast-Fourier-Transformation (FFT), in Frequenzanteile zu zerlegen und auszuwerten. Basierend auf dieser Frequenzbestimmung kann dann eine Entfernungsinformation bezüglich einer Entfernung des Radarfüllstandmessgerätes zur Oberfläche des Mediums und/oder ein Füllstand des Mediums ermittelt werden.

Gemäß einer Ausführungsform weist das Radarfüllstandmessgerät und/oder das Radarmodul weiter einen Verstärker zur Verstärkung eines von einem Frequenzmischer des Radarfüllstandmessgeräts ausgegebenen Zwischenfrequenzsignals auf. Alternativ oder zusätzlich weist das Radarmodul und/oder das Radarfüllstandmessgerät ein Filter auf, welches zwischen eine digitale Steuereinheit und einen Frequenzmischer des Radarfüllstandmessgeräts gekoppelt ist. Das Filter kann ein Hochpassfilter oder ein Tiefpassfilter sein. Alternativ oder zusätzlich weist das Radarmodul und/oder das Radarfüllstandmessgerät einen Analog-Digital-Wandler auf, welcher zwischen eine digitale Steuereinheit und einen Frequenzmischer des Radarfüllstandmessgeräts gekoppelt ist, wobei der Analog-Digital-Wandler dazu ausgeführt ist, ein mit einem von dem Frequenzmischer ausgegebenen Zwischenfrequenzsignal korrelierendes digitales Messsignal zu erzeugen.

Gemäß einer Ausführungsform weist das Radarfüllstandmessgerät und/oder das Radarmodul weiter einen Referenzoszillator auf, welcher mit dem Referenzeingang des Phasendetektors gekoppelt ist und welcher dazu ausgeführt ist, Referenzfrequenzsignale zu erzeugen. Der Referenzoszillator kann dabei etwa als Quarzoszillator ausgeführt sein, welcher frequenzstabile Referenzfrequenzsignale erzeugen und/oder bereitstellen kann.

Gemäß einer Ausführungsform weist das Radarfüllstandmessgerät und/oder das Radarmodul weiter einen mit dem Ausgang des Oszillators gekoppelten Verstärker zur Verstärkung des Ausgangssignals des Oszillators auf. Der Verstärker kann etwa in der Sende-Empfangsweiche integriert sein.

Ein weiterer Aspekt der Erfindung betrifft die Verwendung eines Radarfüllstandmessgeräts, so wie voranstehend und nachfolgend beschrieben, zur Bestimmung eines Füllstandes eines Mediums.

Ein weiterer Aspekt der Erfindung betrifft ein Verfahren zum Betreiben eines Radarfüllstandmessgeräts, so wie voranstehend und nachfolgend beschrieben. Gleichsam kann das erfindungsgemäße Verfahren eine Verfahren zur Ermittlung eines Füllstandes eines Mediums unter Verwendung eines

Radarfüllstandmessgerätes, so wie voranstehend und nachfolgend beschrieben, bezeichnen. Das Verfahren weist die folgenden Schritte auf:
- Erzeugen, mit dem Radarmodul des Radarfüllstandmessgeräts, eines Sendesignals, welches eine Frequenz bzw. eine Sendefrequenz von wenigstens 60 GHz aufweist;
- Abstrahlen, mit der wenigstens einen Antenne des Radarfüllstandmessgeräts, des Sendesignals in Richtung einer Oberfläche eines Mediums;
- Empfangen, mit der wenigstens einen Antenne des Radarfüllstandmessgeräts, eines an der Oberfläche des Mediums reflektierten Empfangssignals;
- Mischen, mit einem Frequenzmischer des Radarfüllstandmessgeräts, des Sendesignals mit dem Empfangssignal zur Erzeugung eines Zwischenfrequenzsignals; und
- Auswerten, mit einer digitalen Steuereinheit des Radarfüllstandmessgeräts, eines mit dem Zwischenfrequenzsignal korrelierenden digitalen Messsignals unter Ermitteln einer Entfernung des Radarfüllstandmessgeräts zu der Oberfläche des Mediums und/oder unter Ermitteln eines Füllstandes des Mediums.

Merkmale und/oder Elemente des Radarfüllstandmessgeräts, so wie voranstehend und nachfolgend beschrieben, können Merkmale, Elemente und/oder Schritte des Verfahrens, so wie voranstehend und nachfolgend beschrieben, sein. Ebenso können Merkmale, Elemente und/oder Schritte des Verfahrens, so wie voranstehend und nachfolgend beschrieben, Merkmale und/oder Elemente des Radarfüllstandmessgeräts, so wie voranstehend und nachfolgend beschrieben, sein.

Im Folgenden werden Ausführungsbeispiele unter Bezugnahme auf die Figuren beschrieben. Dabei können gleiche Bezugszeichen gleiche, gleichwirkende oder ähnliche Elemente bezeichnen.

### Kurze Beschreibung der Figuren

Fig. 1 zeigt ein Blockschaltbild eines Radarfüllstandmessgeräts gemäß einem Ausführungsbeispiel der Erfindung.
Fig. 2 zeigt ein Blockschaltbild eines Radarfüllstandmessgeräts gemäß einem Ausführungsbeispiel der Erfindung.
Fig. 3 zeigt ein Blockschaltbild eines Radarfüllstandmessgeräts gemäß einem Ausführungsbeispiel.
Fig. 4 zeigt ein Blockschaltbild eines Radarfüllstandmessgeräts gemäß einem Ausführungsbeispiel.
Fig. 5 zeigt ein Blockschaltbild eines Radarfüllstandmessgeräts gemäß einem Ausführungsbeispiel.
Fig. 6 zeigt ein Blockschaltbild eines Radarfüllstandmessgeräts gemäß einem Ausführungsbeispiel.
Fig. 7 zeigt ein Flussdiagramm zur Illustration von Schritten eines Verfahrens zum Betreiben eines Radarfüllstandmessgerätes gemäß einem Ausführungsbeispiel.

Die Darstellungen in den Figuren sind lediglich schematisch und nicht maßstabsgetreu.

### Detaillierte Beschreibung von Ausführungsbeispielen

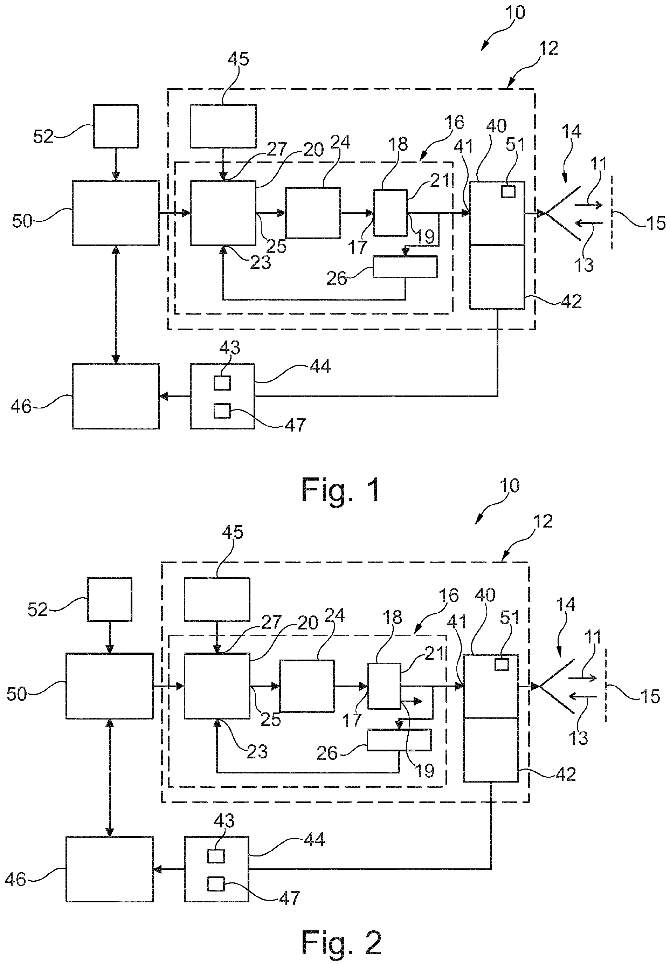

Fig. 1 zeigt ein Blockschaltbild eines Radarfüllstandmessgeräts 10 gemäß einem Ausführungsbeispiel der Erfindung.

Das Radarfüllstandmessgerät 10 weist ein Radarmodul 12 zur Erzeugung eines Sendesignals 11 sowie eine mit dem Radarmodul 12 gekoppelte Antenne 14 auf. Über die Antenne 12 kann das Sendesignal 11 in Richtung einer Oberfläche 15 eines Mediums abgestrahlt und/oder ausgesendet werden und ein an der Oberfläche 15 reflektiertes Empfangssignal 13 kann mit der Antenne 14 empfangen werden. Die Antenne 12 kann jede beliebige Antenne 12 sein, etwa eine Hornantenne, eine Linsenantenne oder eine Parabolantenne. Das Sendesignal 11 weist dabei eine Sendefrequenz von wenigstens 60 GHz auf.

Das Radarmodul 12 weist einen Phasenregelkreis 16 auf, welcher einen Oszillator 18 und einen mit dem Oszillator 18 gekoppelten Phasendetektor 20 aufweist. Der Phasendetektor 20 kann ein fractionaler Phasendetektor 20, auch Fract-N-PLL genannt, und/oder ein integer Phasendetektor 20 sein, auch Int-N-PLL genannt. Ferner weist der Phasenregelkreis 16 einen Frequenzteiler 26 auf, welcher zwischen einen Ausgang 19 des Oszillators 18 und einen Eingang 23 des Phasendetektors 20 gekoppelt ist. Des Weiteren weist der Phasenregelkreis 16 ein Schleifenfilter 24 auf, welches zwischen einen Phasendetektorausgang 25 des Phasendetektors 20 und einen Steuereingang 17 des Oszillators 18 gekoppelt ist.

Der Oszillator 18 ist ein spannungsgesteuerter Oszillator 18 (VCO), welcher als Grundwellenoszillator 18 bzw. spannungsgesteuerter Grundwellenoszillator 18 ausgeführt ist. Der Oszillator 18 gibt an dem direkt mit dem Eingang 41 der Sende-Empfangsweiche 40 verbundenen Ausgang 19 ein Ausgangssignal mit einer Grundfrequenz des Oszillators 18 aus. Mit anderen Worten kann eine Ausgangsfrequenz des am Ausgang 19 des Oszillators 18 ausgegebenen Ausgangssignals der Grundfrequenz des Oszillators 18 entsprechen. Der Oszillator 18 kann zudem einen weiteren Ausgang 21 aufweisen, etwa einen Hochfrequenzausgang 21, welcher nicht an weitere Komponenten des Radarmoduls 12 gekoppelt ist und an welchem daher kein Signal abgegriffen wird.

Des Weiteren weist das Radarmodul 12 einen Referenzoszillator 45 auf, welcher mit einem Referenzeingang 27 des Phasendetektors 20 gekoppelt ist. Ferner weist das Radarmodul 12 eine Sende-Empfangsweiche 40 auf, welche zwischen den Oszillator 18 und die Antenne 14 gekoppelt ist und welche dazu ausgeführt ist, das Sendesignal 11 und das zeitlich relativ zum Sendesignal 11 verzögerte Empfangssignal 13 zu trennen. Dabei ist der Ausgang 19 des Oszillators 18 direkt und/oder unmittelbar mit einem Eingang 41 der Sende-Empfangsweiche verbunden, verschaltet und/oder gekoppelt. Mit anderen Worten ist in der elektrischen Verbindung zwischen Ausgang 19 des Oszillators 18 und Eingang 41 der Sende-Empfangsweiche 40 kein weiteres Bauteil, wie etwa ein Frequenzvervielfacher, vorgesehen. Dadurch kann in vorteilhafter Weise eine Leistungsaufnahme, eine Baugröße und/oder ein Schaltungsaufwand des Radarfüllstandmessgeräts 10 reduziert sein. Zudem wird in vorteilhafter Weise ein Phasenrauschen des Oszillators 18 durch Entfall eines weiteren Bauteils wie einen Frequenzvervielfacher nicht vervielfacht. Der Oszillator 18 kann etwa auf Silizium-Germanium-Technologie (SiGe) basieren, so dass der Oszillator 18 selbst im mm-Wellen-Bereich als Grundwellenoszillator 18 ausgelegt werden kann. Hierdurch reduziert sich der Schaltungsaufwand für den Sendezweig des Radarfüllstandmessgeräts 10 erheblich, und es kann vollständig auf einen Frequenzvervielfacher verzichtet werden. Hierdurch reduziert sich auch die Energieaufnahme des gesamten Sendezweiges deutlich. Zudem kann der Frequenzteiler 26, welcher etwa ein Prescaler 26 bzw. Vorteiler 26 sein kann, verhältnismäßig einfach und mit einer geringeren Leistungsaufnahme als ein Frequenzvervielfacher aufgebaut werden.

Das Radarfüllstandmessgerät 10 und/oder das Radarmodul 12 weist ferner einen Frequenzmischer 42 auf, welcher mit der Sende-Empfangsweiche 40 gekoppelt ist und welcher basierend auf dem Sendesignal 11 sowie dem Empfangssignal 13 ein Zwischenfrequenzsignal erzeugt, welches eine Frequenz entsprechend einer Differenz der Sendefrequenz des Sendesignals 11 und einer Frequenz des Empfangssignals 13 aufweist.

Der Frequenzmischer 42 ist ferner mit einer Elektronikanordnung 44 verbunden und/oder gekoppelt. Die Elektronikanordnung 44 weist ein Filter 43, etwa ein Hochpassfilter 43 oder ein Tiefpassfilter 43, zum Filtern des Zwischenfrequenzsignals und einen Verstärker 47 zum Verstärken des gefilterten Zwischenfrequenzsignals auf.

Über einen Analog-Digital-Wandler 46 des Radarfüllstandmessgeräts 10 wird das gefilterte und verstärkte Zwischenfrequenzsignal in ein digitales Messsignal überführt und einer digitalen Steuereinheit 50 des Radarfüllstandmessgeräts 10 zur eigentlichen Ermittlung eines Füllstandes des Mediums zugeführt. Die digitale Steuereinheit kann beispielsweise als digitaler Signalprozessor (DSP) und/oder als Mikrokontroller ausgeführt sein. Die digitale Steuereinheit 50 kann etwa das digitale Messsignal basierend auf einer Fourier-Transformation, insbesondere einer Fast-Fourier-Transformation, in Frequenzanteile zerlegen und basierend auf einer Auswertung der Frequenzanteile eine Entfernung zwischen dem Radarfüllstandmessgerät 10 und der Oberfläche 15 des Mediums und/oder einen Füllstand des Mediums ermitteln. Dazu ist die Steuereinheit 50 ferner mit einem Quarzoszillator 52 als Taktgeber gekoppelt.

Eine Regelung der Sendefrequenz des Sendesignals 11 durch den Phasenregelkreis 16 und/oder weitere Komponenten des Radarmoduls 12 während eines Messzyklus kann wie nachfolgend beschrieben erfolgen. Der Oszillator 18 erzeugt ein Ausgangssignal und gibt dieses an dem Ausgang 19 aus. Das Ausgangssignal kann etwa eine Ausgangsfrequenz von wenigstens 60 GHz aufweisen. Das Ausgangssignal wird dem Frequenzteiler 26 zugeführt, welcher ein frequenzgeteiltes Signal, d.h. ein relativ zum Ausgangssignal in der Frequenz reduziertes Signal, erzeugt. Dies kann erforderlich sein, da der Phasendetektor 20 unter Umständen keine allzu hohen Frequenzen verarbeiten kann. Das frequenzgeteilte Signal wird anschließend über den Eingang 23 des Phasendetektors 20 dem Phasendetektor zugeführt. Ferner empfängt der Phasendetektor 20 an dem Referenzeingang 27 ein Referenzfrequenzsignal von dem Referenzoszillator 45. Der Phasendetektor 20 wird dabei mit digitalen Steuersignalen von der Steuereinheit 50 beaufschlagt, über welche der Phasendetektor 20 gesteuert und/oder geregelt wird. Der Phasendetektor 20 ermittelt nun einen Phasenunterschied und/oder eine Phasendifferenz zwischen dem Referenzfrequenzsignal und dem frequenzgeteilten Signal. Je nach Ansteuerung des Phasendetektors 20 mit den digitalen Steuersignalen der Steuereinheit und je nach ermitteltem Phasenunterschied generiert der Phasendetektor 20 ein mit dem ermittelten Phasenunterschied korrelierendes Regelsignal und gibt dieses an dem Phasendetektorausgang 25 aus. Das Regelsignal kann etwa ein Pulspaket sein. Das Regelsignal wird anschließend dem Schleifenfilter 24 zugeführt, welcher ein gefiltertes Regelsignal generiert und an den Steuereingang 17 des Oszillators 18 ausgibt. In Abhängigkeit des Regelsignals kann so die Grundschwingung des Oszillators 18, etwa über eine Varaktordiode des Oszillators 18, in der Frequenz variiert werden und entsprechend können die Ausgangsfrequenz des Ausgangssignals des Oszillators 18 sowie die Sendefrequenz des Sendesignals 11 variiert werden. Je nach Ansteuerung des Phasenregelkreises 20 mit den digitalen Steuersignalen der Steuereinheit 50 kann mit dem Radarmodul 12 während eines Messzyklus eine lineare, kontinuierliche Frequenzrampe ("Frequency-Modulated-Continuous-Wave, FMCW"), eine gestufte Frequenzrampe ("Stepped-Frequency-Continuous-Wave") oder ein Dauerstrich-Signal ("Continuous-Wave-Signal, CW-Signal") erzeugt werden.

Das von dem Oszillator 18 an dessen Ausgang 19 ausgegebene Ausgangssignal wird anschließend der Sende-Empfangsweiche 40 zugeführt. In der Sende-Empfangsweiche kann ferner ein Verstärker 51 zur Verstärkung des Ausgangssignals des Oszillators 18 integriert sein. Das gegebenenfalls verstärkte Ausgangssignal wird in die Antenne 14 eingekoppelt und als Sendesignal 11 abgestrahlt.

Wie voranstehend bereits erläutert wird das Sendesignal 11 und das an der Oberfläche 15 des Mediums reflektierte Empfangssignal 13 dem Frequenzmischer 42 zugeführt, welcher das Zwischenfrequenzsignal erzeugt. Das Zwischenfrequenzsignal wird durch das Filter 43 gefiltert, durch den Verstärker 47 verstärkt und durch den Analog-Digital-Wandler 46 in das digitale Messsignal gewandelt, welches von der Steuereinheit 50 unter Ermittlung des Füllstandes ausgewertet wird. Wenn das Radarfüllstandmessgerät 10 als SFCW-Messgerät ausgeführt ist, kann das Filter 43 ein Tiefpassfilter 43 sein. Wenn das Radarfüllstandmessgerät 10 als FMCW-Messgerät ausgeführt ist, kann das Filter 43 ein Hochpassfilter 43 sein.

Fig. 2 zeigt ein Blockschaltbild eines Radarfüllstandmessgeräts 10 gemäß einem Ausführungsbeispiel der Erfindung. Sofern nicht anders beschrieben, weist das Radarfüllstandmessgerät 10 der Figur 2 dieselben Elemente, Komponenten und/oder Funktionen wie das Radarfüllstandmessgerät 10 der Figur 1 auf.

Im Speziellen unterscheidet sich das Radarfüllstandmessgerät 10 der Figur 2 lediglich hinsichtlich des Oszillators 18 von dem Radarfüllstandmessgerät 10 der Figur 1. Abgesehen von dem Oszillator 18 gilt daher sämtliche Offenbarung bezüglich des Radarfüllstandmessgeräts 10 der Figur 1 gleichsam für das Radarfüllstandmessgerät 10 der Figur 2. Diese Offenbarung der Figur 1 wird daher hiermit durch Referenzierung einbezogen, um Wiederholungen zu vermeiden.

Im Gegensatz zu dem Oszillator 18 der Figur 1 ist der Oszillator 18 der Figur 2 ein Push-Push-Oszillator 18. Dabei ist ein Ausgang 21 des Push-Push-Oszillators 18 direkt mit dem Eingang 41 der Sende-Empfangsweiche 40 gekoppelt, verbunden und/oder verschaltet. Dieser Ausgang 21 ist ein Hochfrequenzausgang 21, und ein weiterer Ausgang 19 des Push-Push-Oszillators 18, welcher etwa ein niederfrequenter Ausgang 19 sein kann, ist nicht mit weiteren Komponenten des Radarfüllstandmessgeräts 10 verbunden.

An dem direkt mit dem Eingang 41 der Sende-Empfangsweiche verbundenen Ausgang 21 des Push-Push-Oszillators 18 gibt der Push-Push-Oszillator 18 eine erste Oberwelle als Ausgangssignal aus. Die Ausgangsfrequenz des Ausgangssignal kann somit etwa der doppelten Frequenz einer Grundfrequenz des Oszillators 18 entsprechen. Analog zu den Erläuterungen bei Figur 1 kann die Grundfrequenz und somit auch die Frequenz der Oberwelle und/oder die Ausgangsfrequenz des Oszillators 18 über das gefilterte Regelsignal, welches über den Frequenzteiler 26, den Phasendetektor 20, die Steuereinheit 50, und/oder das Schleifenfilter 24 erzeugt wird, etwa durch entsprechende Ansteuerung einer Varaktordiode des Oszillators 18 in der Frequenz variiert werden. Damit wird auch die Sendefrequenz des Sendesignals 11 analog zu den Erläuterungen der Figur 1 variiert.

Wird, wie voranstehend erläutert, die erste Oberwelle an dem Ausgang 21 des Push-Push-Oszillators 18 gezielt ausgekoppelt, so kann die Grundfrequenz f₀ des Push-Push-Oszillators 18 beispielsweise 40 GHz betragen und die Sendefrequenz des Radarfüllstandmessgeräts 10 kann beispielsweise 80 GHz betragen.

Gegenüber anderen Oszillatoren 18, wie etwa Grundwellenoszillatoren, kann der Einsatz eines Push-Push-Oszillators 18 weitere Vorteile bieten. Bei Verwendung des Push-Push-Oszillators 18 kann etwa eine größere Abstimmbandbreite des Ausgangssignals, etwa die doppelte Bandbreite wie bei der Grundfrequenz f₀, gegenüber der Verwendung eines Grundwellenoszillators bei 80GHz erzielt werden. Auch kann das Phasenrauschen bei einem bei 40 GHz betriebene Push-Push-Oszillator 18 deutlich besser als bei einem 80 GHz Grundwellenoszillator sein.

Ferner sei bemerkt, dass bei dem Ausführungsbeispiel der Figur 2 der Frequenzteiler 26 auch an den niederfrequenteren Ausgang 19 des Oszillators 18 angeschlossen werden könnte und daher einfacher ausgeführt werden könnte. Der Anschluss des Frequenzteilers 26 an den Hochfrequenzausgang 21 hat jedoch zur Folge, dass alle Einflüsse des Phasenrauschens im Oszillator 18 in dem Phasenregelkreis 16 berücksichtigt werden und damit etwas bessere Messergebnisse erzielt werden können als bei Anschluss des Frequenzteilers 26 an den niederfrequenten Ausgang 19.

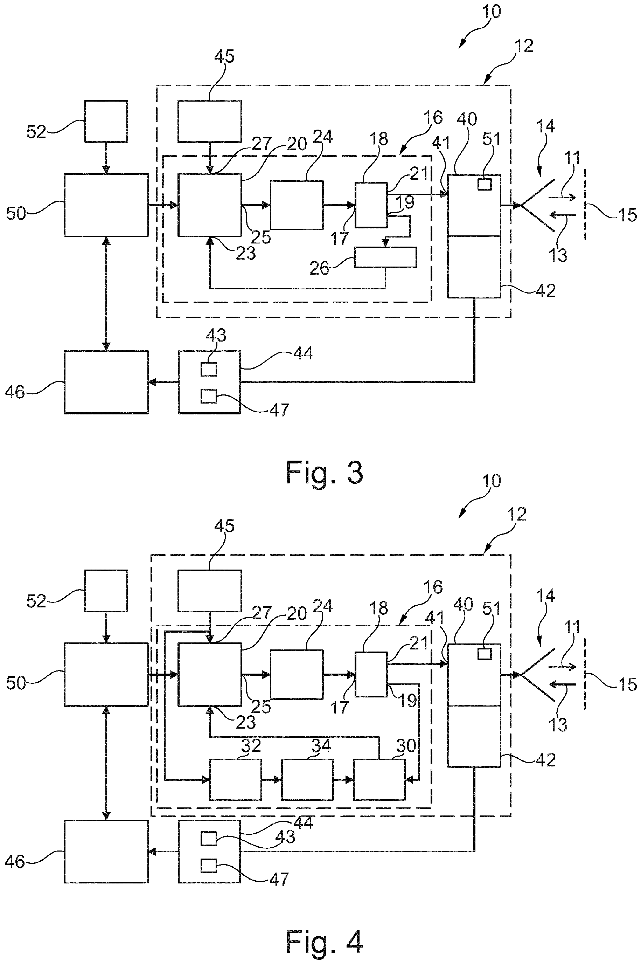

Fig. 3 zeigt ein Blockschaltbild eines Radarfüllstandmessgeräts 10 gemäß einem Ausführungsbeispiel. Sofern nicht anders beschrieben, weist das Radarfüllstandmessgerät 10 der Figur 3 dieselben Elemente, Komponenten und/oder Funktionen wie die Radarfüllstandmessgeräte 10 der Figuren 1 und 2 auf.

Im Speziellen unterscheidet sich das Radarfüllstandmessgerät 10 der Figur 3 lediglich hinsichtlich des Oszillators 18 von dem Radarfüllstandmessgerät 10 der Figur 1. Abgesehen von dem Oszillator 18 gilt daher sämtliche Offenbarung bezüglich des Radarfüllstandmessgeräts 10 der Figur 1 gleichsam für das Radarfüllstandmessgerät 10 der Figur 3. Diese Offenbarung der Figur 1 wird daher hiermit durch Referenzierung einbezogen, um Wiederholungen zu vermeiden.

Ferner unterscheidet sich bei dem in Figur 3 gezeigten Ausführungsbeispiel lediglich die Verschaltung des Oszillators 18 gegenüber der Verschaltung des Oszillators 18 aus Figur 2, d.h. auch der Oszillator 18 der Figur 3 ist ein Push-Push-Oszillator 18, wie bei Figur 2 beschrieben. Im Speziellen ist bei dem in Figur 3 gezeigten Ausführungsbeispiel der Hochfrequenzausgang 21 des Oszillators 18, wie bei Figur 2 erläutert, direkt mit dem Eingang 41 der Sende-Empfangsweiche 40 verbunden, so dass die erste Oberwelle mit der doppelten Grundfrequenz f₀ an den Eingang 41 der Sende-Empfangsweiche 40 ausgegeben wird. Im Gegensatz zu Figur 2 ist jedoch der Ausgang 19 des Push-Push-Oszillators 18, d.h. der niederfrequente Ausgang 19, mit dem Frequenzteiler 26 gekoppelt, so dass dem Frequenzteiler 26 ein Ausgangssignal mit der Grundfrequenz f₀ des Oszillators 18 zugeführt wird. Dadurch kann der Frequenzteiler 26 im Vergleich zu dem Frequenzteiler 26 der Figur 2 vereinfacht ausgeführt werden. Abgesehen von der Verschaltung des Oszillators 18 an den Ausgängen 19, 21 gilt jedoch sämtliche Offenbarung der Figur 2 bezüglich des dort beschriebenen Oszillators 18 gleichsam für Figur 3 und wird hiermit durch Referenzierung einbezogen.

Fig. 4 zeigt ein Blockschaltbild eines Radarfüllstandmessgeräts 10 gemäß einem Ausführungsbeispiel. Sofern nicht anders beschrieben, weist das Radarfüllstandmessgerät 10 der Figur 4 dieselben Elemente, Komponenten und/oder Funktionen wie die Radarfüllstandmessgeräte 10 der Figuren 1 bis 3 auf.

Im Speziellen unterscheidet sich das Radarfüllstandmessgerät 10 der Figur 4 lediglich in dem Rückkoppelzweig des Phasenregelkreises 16 zwischen Oszillator 18 und Phasendetektor 20 von den Radarfüllstandmessgeräten 10 der Figuren 1 bis 3. Sämtliche anderweitige Offenbarung der Figuren 1 bis 3 wird daher hiermit durch Referenzierung einbezogen.

In dem Rückkoppelzweig des Phasenregelkreises 16 der Figur 4 ist anstelle des Frequenzteilers 26 der Figuren 1 bis 3 ein weiterer Frequenzmischer 30 verbaut. Dieser weitere Frequenzmischer 30 ist mit dem niederfrequenten Ausgang 19 des Oszillators 18 gekoppelt. Der Hochfrequenzausgang 21 des Oszillators 18 ist ferner mit dem Eingang 41 der Sende-Empfangsweiche 40 direkt verbunden. Der Oszillator 18 der Figur 4 ist ferner ein Push-Push-Oszillator 18, wie bei den Figuren 2 und 3 beschrieben, wobei der Oszillator 18 der Figur 4 wie bei Figur 3 beschrieben verschaltet ist.

Im Gegensatz zu den Radarfüllstandmessgeräten 10 der Figuren 1 bis 3 weist der Rückkoppelzweig des Phasenregelkreises 16 ferner einen weiteren Phasendetektor 32 und einen weiteren Oszillator 34 auf. Der weitere Phasendetektor 32 kann etwa ein integer Phasendetektor 32 (Int-N-PLL) und der weitere Oszillator 34 kann ein VCO, ein Grundwellenoszillator oder ein Push-Push-Oszillator sein. Der Phasendetektor 20 kann dagegen ein fraktionaler Phasendetektor (Fract-N-PLL) und/oder ein integer Phasendetektor (Int-N-PLL) sein.

Zur Regelung der Grundfrequenz, der am Hochfrequenzausgang 21 ausgegebenen Ausgangsfrequenz des Ausgangssignals des Oszillators 18 und/oder zur Regelung der Sendefrequenz des Sendesignals 11 wird das Referenzfrequenzsignal des Referenzoszillators 45 sowohl an den Referenzeingang 27 des Phasendetektors 20 als auch an einen Eingang des weiteren Phasendetektors 32 angelegt. Der weitere Phasendetektor 32 gibt dann ein Steuersignal an den weiteren Oszillator 34 aus und steuert bzw. regelt damit eine Ausgangsfrequenz eines von dem weiteren Oszillator 34 ausgegebenen weiteren Ausgangssignals. Dieses weitere Ausgangssignal wird dem weiteren Frequenzmischer 30 zugeführt. Auch wird dem weiteren Frequenzmischer 30 das am niederfrequenten Ausgang 19 des Oszillators 18 ausgegebene Ausgangssignal, welches die Grundfrequenz f₀ des Oszillators 18 aufweist, zugeführt. Der weitere Frequenzmischer 30 mischt dann das am Ausgang 19 ausgegebene Ausgangssignal basierend auf dem weiteren Ausgangssignal des weiteren Oszillators 34, etwa durch Differenzbildung, herunter und gibt ein weiteres Zwischenfrequenzsignal an den Eingang 23 des Phasendetektors 20 aus. Der Phasendetektor 20 ermittelt dann analog den Ausführungen zu Figur 1 einen Phasenunterschied zwischen dem weiteren Zwischenfrequenzsignal und dem Referenzfrequenzsignal des Referenzoszillators 45 und gibt ein mit dem Phasenunterschied korrelierendes Regelsignal an das Schleifenfilter 24 und/oder an den Oszillator 18 aus, so dass die Sendefrequenz des Sendesignals 11 geregelt wird. Mit der Ausführung des Radarfüllstandmessgeräts 10 der Figur 4 kann ein verhältnismäßig gutes Phasenrauschen erzielt werden.

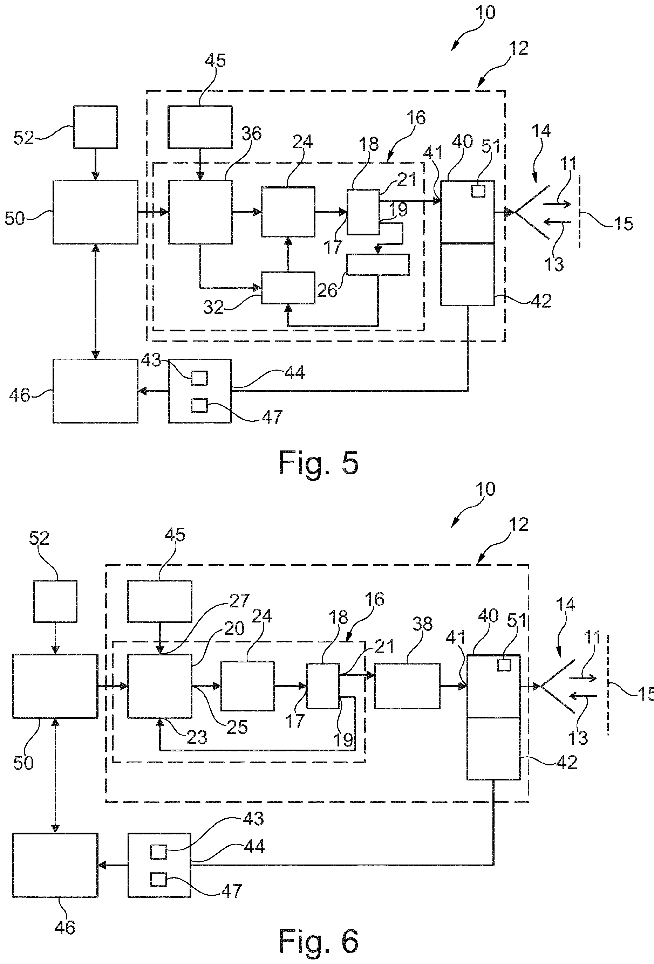

Fig. 5 zeigt ein Blockschaltbild eines Radarfüllstandmessgeräts 10 gemäß einem Ausführungsbeispiel. Sofern nicht anders beschrieben, weist das Radarfüllstandmessgerät 10 der Figur 5 dieselben Elemente, Komponenten und/oder Funktionen wie die Radarfüllstandmessgeräte 10 der Figuren 1 bis 4 auf.

Im Speziellen unterscheidet sich das Radarfüllstandmessgerät 10 der Figur 5 lediglich in dem Rückkoppelzweig des Phasenregelkreises 16 zwischen Oszillator 18 und Phasendetektor 20 von den Radarfüllstandmessgeräten 10 der Figuren 1 bis 4. Sämtliche anderweitige Offenbarung der Figuren 1 bis 4 wird daher hiermit durch Referenzierung einbezogen.

Im Rückkoppelzweig des Phasenregelkreises 16 weist das Radarfüllstandmessgerät 10 der Figur 5 anstelle des Phasendetektors 20 der vorangegangenen Figuren einen Direct Digital Synthesizer, DDS, 36 auf. Zudem ist im Rückkoppelzweig ein Phasendetektor 32 angeordnet, etwa ein integer Phasendetektor 32 (Int-N-PLL).

Der Oszillator 18 der Figur 5 ist ein Push-Push-Oszillator 18, wobei die erste Oberwelle am Hochfrequenzausgang 21 dem Eingang 41 der Sende-Empfangsweiche 40 zugeführt wird. Der niederfrequente Ausgang 19 des Oszillators 18 ist dagegen mit dem Frequenzteiler 26 gekoppelt. Der Oszillator 18 der Figur 5 ist somit analog zu den Oszillatoren 18 der Figuren 3 und 4 verschaltet.

Das niederfrequente Ausgangssignal des Oszillators 18, welches die Grundfrequenz des Oszillators 18 aufweist, wird durch den Frequenzteiler frequenzgeteilt und dem Phasendetektor 32 zugeführt. Ferner wird die DDS 36 mit den digitalen Steuersignalen der Steuereinheit 50 sowie mit den Referenzfrequenzsignalen des Referenzoszillators 45 beaufschlagt. Die DDS 36 gibt dann ein entsprechendes Signal an den Phasendetektor 32 aus und der Phasendetektor 32 ermittelt einen Phasenunterschied zwischen dem frequenzgeteilten Signal und dem Signal der DDS 36. Der Phasendetektor 32 gibt wiederum ein mit dem Phasenunterschied korrelierendes Regelsignal an das Schleifenfilter 24 und/oder an den Steuereingang 17 des Oszillators 18 aus, so dass damit die Sendefrequenz des Sendesignals 11 geregelt wird.

Fig. 6 zeigt ein Blockschaltbild eines Radarfüllstandmessgeräts 10 gemäß einem Ausführungsbeispiel. Sofern nicht anders beschrieben, weist das Radarfüllstandmessgerät 10 der Figur 6 dieselben Elemente, Komponenten und/oder Funktionen wie die Radarfüllstandmessgeräte 10 der Figuren 1 bis 5 auf.

Das Ausführungsbeispiel der Figur 6 entspricht im Wesentlichen dem Ausführungsbeispiel der Figur 3 mit dem Unterschied, dass der Oszillator 18, welcher ein Push-Push-Oszillator 18 ist, im niederfrequenten Bereich betrieben wird. Beispielsweise kann der Oszillator 18 bei einer Grundfrequenz f₀ von rund 5 GHz betrieben werden. Der niederfrequente Ausgang 19 des Oszillators 18 ist dabei direkt und/oder unmittelbar mit dem Eingang 23 des Phasendetektors 20 verbunden, gekoppelt und/oder verschaltet. Durch Betrieb des Oszillators 18 im niederfrequenten Bereich kann so in vorteilhafter Weise auf den Einsatz eines Frequenzteilers 26, wie z.B. bei Figur 3 erläutert, verzichtet werden und das niederfrequente Ausgangssignal des Oszillators 18 kann direkt dem Phasendetektor 20 zugeführt werden. Der Phasendetektor 20 ermittelt wiederum einen Phasenunterschied zwischen dem niederfrequenten Ausganssignal des Oszillators 18 und dem Referenzfrequenzsignal des Referenzoszillators 45 und gibt an dem Phasendetektorausgang 25 ein mit dem Phasenunterschied korrelierendes Regelsignal an das Schleifenfilter 24 und/oder an den Steuereingang 17 des Oszillators 18 aus, so dass die Sendefrequenz des Sendesignals 11 geregelt werden kann. Durch einen derartigen Schaltungsaufbau des Radarmoduls 12 kann daher in vorteilhafter Weise auf einen Frequenzteiler 26, wie z.B. bei Figur 3 gezeigt, verzichtet werden. Insgesamt kann so ein Schaltungsaufwand sowie eine Baugröße des Radarmoduls 12 reduziert sein.

Der Hochfrequenzausgang 21 des Oszillators 18, an welchem die erste Oberwelle mit der doppelten Grundfrequenz f₀ als Ausgangssignal ausgegeben wird (wie z.B. bei Fig. 3 beschrieben), ist zudem mit einem Frequenzvervielfacher 38 gekoppelt. Insbesondere kann der Frequenzvervielfacher 38 das am Hochfrequenzausgang 21 ausgegebene Ausgangssignal des Oszillators 18 um wenigstens einen Faktor vier, etwa wenigstens einen Faktor sechs und insbesondere wenigstens einen Faktor acht erhöhen. Bei Betreiben des Oszillators 18 mit einer Grundfrequenz von 5 GHz kann so ein Sendesignal 11 mit einer Sendefrequenz von rund 80 GHz erzeugt werden

Es sei an dieser Stelle betont, dass sämtliche Offenbarung zu den in Figuren 1 bis 5 beschriebenen Radarfüllstandmessgeräten 10, abgesehen von den voranstehend erläuterten Unterschieden, gleichsam für das Radarfüllstandmessgerät 10 der Figur 6 gilt und daher hiermit durch Referenzierung einbezogen ist.

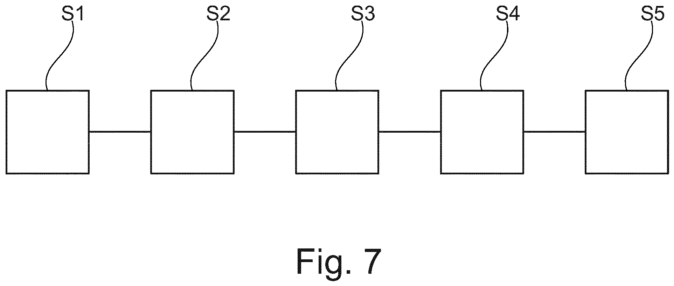

Fig. 7 zeigt ein Flussdiagramm zur Illustration von Schritten eines Verfahrens zum Betreiben eines Radarfüllstandmessgerätes 10 gemäß einem Ausführungsbeispiel. Das Radarfüllstandmessgerät 10 kann dabei eines der Radarfüllstandmessgeräte 10 der Figuren 1 bis 6 sein.

In einem ersten Schritt S1 wird mit dem Radarmodul 12 des Radarfüllstandmessgeräts 10 ein Sendesignal 11 erzeugt, welches eine Frequenz bzw. eine Sendefrequenz von wenigstens 60 GHz aufweist. In einem weiteren Schritt S2 wird mit der wenigstens einen Antenne 14 des Radarfüllstandmessgeräts 10 das Sendesignal 11 in Richtung einer Oberfläche 15 eines Mediums abgestrahlt. In einem weiteren Schritt S3 wird mit der wenigstens einen Antenne 14 des Radarfüllstandmessgeräts 10 ein an der Oberfläche 15 des Mediums reflektiertes Empfangssignal 13 empfangen. In einem weiteren Schritt S4 wird mit einem Frequenzmischer 42 des Radarfüllstandmessgeräts 10 das Sendesignal 11 mit dem Empfangssignal 13 zur Erzeugung eines Zwischenfrequenzsignals gemischt. In einem weiteren Schritt S5 wird mit einer digitalen Steuereinheit 50 des Radarfüllstandmessgeräts 10 ein mit dem Zwischenfrequenzsignal korrelierendes digitales Messsignal ausgewertet. Das Messsignal kann dabei unter Ermitteln einer Entfernung des Radarfüllstandmessgeräts 10 zu der Oberfläche 15 des Mediums und/oder unter Ermitteln eines Füllstandes des Mediums ausgewertet werden.

Ergänzend sei daraufhingewiesen, dass "umfassend" und "aufweisend" keine anderen Elemente oder Schritte ausschließt und "eine" oder "ein" keine Vielzahl ausschließt. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Radarfüllstandmessgerät (10) zur Bestimmung eines Füllstandes eines Mediums, das Radarfüllstandmessgerät (10) aufweisend:
ein Radarmodul (12) zur Erzeugung eines Sendesignals (11) mit einer Sendefrequenz von wenigstens 60 GHz; und
wenigstens eine mit dem Radarmodul (12) gekoppelte Antenne (14) zum Aussenden des Sendesignals (11) an eine Oberfläche (15) eines Mediums und zum Empfangen eines an der Oberfläche (15) reflektierten Empfangssignals (13);
wobei das Radarmodul (12) aufweist:
- einen Phasenregelkreis (16), welcher einen Oszillator (18) zur Ausgabe eines Ausgangssignals an einem Ausgang (19, 21) des Oszillators (18), einen Phasendetektor (20) und einen zwischen den Ausgang (19, 21) des Oszillators (18) und einen Eingang (23) des Phasendetektors (20) gekoppelten Frequenzteiler (26) zum Erzeugen eines frequenzgeteilten Signals basierend auf dem Ausgangssignal des Oszillators (18) aufweist; und
- eine zwischen den Oszillator (18) und die Antenne (14) gekoppelte Sende-Empfangsweiche (40) zur Trennung des Sendesignals (11) und des Empfangssignals (13),
wobei das Ausgangssignal des Oszillators (18) eine Ausgangsfrequenz von wenigstens 60 GHz aufweist;
wobei der Ausgang (19, 21) des Oszillators (18) direkt mit einem Eingang (41) der Sende-Empfangsweiche (40) verschaltet ist, so dass basierend auf dem Ausgangssignal des Oszillators (18) das Sendesignal (11) über die Antenne (14) abgestrahlt werden kann;
wobei der Frequenzteiler (26) und die Sende-Empfangsweiche (40) mit demselben Ausgang (19, 21) des Oszillators (18) gekoppelt sind;
wobei der Phasendetektor (20) einen Referenzeingang (27) zum Empfangen eines Referenzfrequenzsignals und einen Phasendetektorausgang (25) aufweist, welcher mit einem Steuereingang (17) des Oszillators (18) gekoppelt ist; und
wobei der Phasendetektor (20) dazu ausgeführt ist, einen Phasenunterschied zwischen dem Referenzfrequenzsignal und dem frequenzgeteilten Signal zu ermitteln und an dem Phasendetektorausgang (25) ein mit dem ermittelten Phasenunterschied korrelierendes Regelsignal zur Regelung der Ausgangsfrequenz des Ausgangssignals des Oszillators (18) an den Steuereingang (17) des Oszillators (18) auszugeben.

2. Radarfüllstandmessgerät (10) nach Anspruch 1,
wobei der Oszillator (18) ein Grundwellenoszillator ist; und
wobei der Oszillator (18) dazu ausgeführt ist, an dem direkt mit dem Eingang (41) der Sende-Empfangsweiche (40) verschalteten Ausgang (19) des Oszillators (18) eine Grundfrequenz des Oszillators (18) auszugeben.

3. Radarfüllstandmessgerät (10) nach Anspruch 1,
wobei der Oszillator (18) ein Push-Push-Oszillator ist; und/oder
wobei der Ausgang (21) des Oszillators (18) ein Hochfrequenzausgang (21) des Oszillators (18) ist.

4. Radarfüllstandmessgerät (10) nach Anspruch 3,
wobei der Oszillator (18) dazu ausgeführt ist, an dem direkt mit dem Eingang (41) der Sende-Empfangsweiche (40) verschalteten Ausgang (21) des Oszillators eine erste Oberwelle auszugeben; und/oder
wobei der Oszillator (18) dazu ausgeführt ist, an dem direkt mit dem Eingang (41) der Sende-Empfangsweiche (40) verschalteten Ausgang (21) des Oszillators (18) ein Ausgangssignal mit einer doppelten Frequenz einer Grundfrequenz des Oszillators (18) auszugeben.

5. Radarfüllstandmessgerät (10) nach einem der voranstehenden Ansprüche,
wobei das Radarmodul (12) als V-Band-Radarmodul, als E-Band-Radarmodul, als W-Band-Radarmodul, als F-Band-Radarmodul, als D-Band-Radarmodul, als G-Band-Radarmodul, als Y-Band-Radarmodul und/oder als J-Band-Radarmodul ausgeführt ist.

6. Radarfüllstandmessgerät (10) nach einem der voranstehenden Ansprüche,
wobei der Phasenregelkreis (16) ferner ein zwischen den Phasendetektorausgang (25) des Phasendetektors (20) und den Steuereingang (17) des Oszillators (18) gekoppeltes Schleifenfilter (24) zur Filterung des Regelsignals des Phasendetektors (20) aufweist.

7. Radarfüllstandmessgerät (10) nach einem der voranstehenden Ansprüche, weiter aufweisend:
einen mit der Sende-Empfangsweiche (40) gekoppelten Frequenzmischer (42) zur Erzeugung eines Zwischenfrequenzsignals basierend auf dem Sendesignal (11) und basierend auf dem Empfangssignal (13).

8. Radarfüllstandmessgerät (10) nach einem der voranstehenden Ansprüche, weiter aufweisend:
eine digitale Steuereinheit (50) zur Steuerung des Phasenregelkreises (16) und/oder zur Steuerung des Phasendetektors (20) mit digitalen Steuersignalen.

9. Radarfüllstandmessgerät (10) nach Anspruch 8,
wobei das Radarfüllstandmessgerät (10) als Frequency-Modulated-Continuous-Wave (FMCW) Radar ausgeführt ist; und/oder
wobei das Radarfüllstandmessgerät als Stepped-Frequency-Continuous-Wave (SFCW) Radar ausgeführt ist.

10. Radarfüllstandmessgerät (10) nach einem der Ansprüche 8 oder 9,
wobei die digitale Steuereinheit (50) ferner dazu eingerichtet ist, basierend auf einem von einem Frequenzmischer (42) des Radarfüllstandmessgeräts ausgegebenen Zwischenfrequenzsignal eine Entfernung zu der Oberfläche des Mediums und/oder einen Füllstand des Mediums zu ermitteln.

11. Radarfüllstandmessgerät (10) nach einem der voranstehenden Ansprüche, weiter aufweisend:
einen Verstärker (47) zur Verstärkung eines von einem Frequenzmischer (42) des Radarfüllstandmessgeräts ausgegebenen Zwischenfrequenzsignals; und/oder
ein Filter (43), welches zwischen eine digitale Steuereinheit (50) und einen Frequenzmischer (42) des Radarfüllstandmessgeräts gekoppelt ist; und/oder
einen Analog-Digital-Wandler (46), welcher zwischen eine digitale Steuereinheit (50) und einen Frequenzmischer (42) des Radarfüllstandmessgeräts gekoppelt ist, wobei der Analog-Digital-Wandler (46) dazu ausgeführt ist, ein mit einem von dem Frequenzmischer (42) ausgegebenen Zwischenfrequenzsignal korrelierendes digitales Messsignal zu erzeugen.

12. Radarfüllstandmessgerät (10) nach einem der voranstehenden Ansprüche, weiter aufweisend:
einen Referenzoszillator (45), welcher mit dem Referenzeingang (27) des Phasendetektors (20) gekoppelt ist und welcher dazu ausgeführt ist, Referenzfrequenzsignale zu erzeugen.

13. Radarfüllstandmessgerät (10) nach einem der voranstehenden Ansprüche, weiter aufweisend:
einen mit dem Ausgang (19, 21) des Oszillators (18) gekoppelten Verstärker (51) zur Verstärkung des Ausgangssignals des Oszillators (18).

14. Verwendung des Radarfüllstandmessgeräts (10) nach einem der voranstehenden Ansprüche zur Bestimmung eines Füllstandes eines Mediums.

15. Verfahren zum Betreiben eines Radarfüllstandmessgeräts (10) nach einem der Ansprüche 1 bis 13, das Verfahren aufweisend die Schritte:
Erzeugen, mit dem Radarmodul (12) des Radarfüllstandmessgeräts (10), eines Sendesignals (11), welches eine Frequenz von wenigstens 60 GHz aufweist;
Abstrahlen, mit der wenigstens einen Antenne (14) des Radarfüllstandmessgeräts (10), des Sendesignals (11) in Richtung einer Oberfläche (15) eines Mediums;
Empfangen, mit der wenigstens einen Antenne (14) des Radarfüllstandmessgeräts (10), eines an der Oberfläche (15) des Mediums reflektierten Empfangssignals (13);
Mischen, mit einem Frequenzmischer (42) des Radarfüllstandmessgeräts (10), des Sendesignals (11) mit dem Empfangssignal (13) zur Erzeugung eines Zwischenfrequenzsignals;
Auswerten, mit einer digitalen Steuereinheit (50) des Radarfüllstandmessgeräts (10), eines mit dem Zwischenfrequenzsignal korrelierenden digitalen Messsignals unter Ermitteln einer Entfernung des Radarfüllstandmessgeräts (10) zu der Oberfläche des Mediums und/oder unter Ermitteln eines Füllstandes des Mediums.

## Claims

1. Radar fill level measuring device (10) for determining a fill level of a medium, the radar fill level measuring device (10) comprising:
a radar module (12) for generating a transmission signal (11) having a transmission frequency of at least 60 GHz; and
at least one antenna (14) coupled to the radar module (12) for transmitting the transmission signal (11) to a surface (15) of a medium and for receiving a received signal (13) reflected at the surface (15);
wherein the radar module (12) comprises:
- a phase-locked loop (16) comprising an oscillator (18) for outputting an output signal at an output (19, 21) of the oscillator (18), a phase detector (20) and a frequency divider (26) coupled between the output (19, 21) of the oscillator (18) and an input (23) of the phase detector (20) for generating a frequency-divided signal based on the output signal of the oscillator (18); and
- a transceiver (40) coupled between the oscillator (18) and the antenna (14) for separating the transmission signal (11) and the received signal (13),
wherein the output signal of the oscillator (18) has an output frequency of at least 60 GHz;
wherein the output (19, 21) of the oscillator (18) is directly connected to an input (41) of the transceiver (40), so that based on the output signal of the oscillator (18) the transmission signal (11) can be radiated via the antenna (14);
wherein the frequency divider (26) and the transceiver (40) are coupled to the same output (19, 21) of the oscillator (18);
wherein the phase detector (20) includes a reference input (27) for receiving a reference frequency signal and a phase detector output (25) coupled to a control input (17) of the oscillator (18); and
wherein the phase detector (20) is configured to determine a phase difference between the reference frequency signal and the frequency-divided signal and to output, at the phase detector output (25) to the control input (17) of the oscillator (18), a control signal correlating with the determined phase difference for controlling the output frequency of the output signal of the oscillator (18).

2. Radar fill level measuring device (10) according to claim 1,
wherein the oscillator (18) is a fundamental wave oscillator; and
wherein the oscillator (18) is configured to output a fundamental frequency of the oscillator (18) at the output (19) of the oscillator (18) directly connected to the input (41) of the transceiver (40).

3. Radar fill level measuring device (10) according to claim 1,
wherein the oscillator (18) is a push-push oscillator; and/or
wherein the output (21) of the oscillator (18) is a high-frequency output (21) of the oscillator (18).

4. Radar fill level measuring device (10) according to claim 3,
wherein the oscillator (18) is configured to output a first harmonic at the output (21) of the oscillator directly connected to the input (41) of the transceiver (40); and/or
wherein the oscillator (18) is configured to output an output signal at twice the frequency of a fundamental frequency of the oscillator (18) at the output (21) of the oscillator (18) directly connected to the input (41) of transceiver (40).

5. Radar fill level measuring device (10) according to any of the preceding claims,
wherein the radar module (12) is designed as a V-band radar module, as an E-band radar module, as a W-band radar module, as an F-band radar module, as a D-band radar module, as a G-band radar module, as a Y-band radar module and/or as a J-band radar module.

6. Radar fill level measuring device (10) according to any of the preceding claims,
wherein the phase-locked loop (16) further comprising a loop filter (24) coupled between the phase detector output (25) of the phase detector (20) and the control input (17) of the oscillator (18) for filtering the control signal of the phase detector (20).

7. Radar fill level measuring device (10) according to any of the preceding claims, further comprising:
a frequency mixer (42) coupled to the transceiver (40) for generating an intermediate frequency signal based on the transmission signal (11) and based on the receive signal (13).

8. Radar fill level measuring device (10) according to any of the preceding claims, further comprising:
a digital control unit (50) for controlling the phase-locked loop (16) and/or for controlling the phase detector (20) with digital control signals.

9. Radar fill level measuring device (10) according to claim 8,
wherein the radar fill level measuring device (10) is configured as a Frequency Modulated Continuous Wave (FMCW) radar; and/or
wherein the radar fill level meter is a stepped frequency continuous wave (SFCW) radar.

10. Radar fill level measuring device (10) according to one of claims 8 or 9,
wherein the digital control unit (50) is further configured to determine a distance to the surface of the medium and/or a fill level of the medium based on an intermediate frequency signal output from a frequency mixer (42) of the radar fill level measuring device.

11. Radar fill level measuring device (10) according to any of the preceding claims, further comprising:
an amplifier (47) for amplifying an intermediate frequency signal output from a frequency mixer (42) of the radar fill level measuring device; and/or
a filter (43) coupled between a digital control unit (50) and a frequency mixer (42) of the radar fill level measuring device; and/or
an analog-to-digital converter (46) coupled between a digital control unit (50) and a frequency mixer (42) of the radar fill level measuring device, wherein the analog-to-digital converter (46) is configured to generate a digital measurement signal correlating with an intermediate frequency signal output by the frequency mixer (42).

12. Radar fill level measuring device (10) according to any of the preceding claims, further comprising:
a reference oscillator (45) which is coupled to the reference input (27) of the phase detector (20) and which is configured to generate reference frequency signals.

13. Radar fill level measuring device (10) according to any of the preceding claims, further comprising:
an amplifier (51) coupled to the output (19, 21) of the oscillator (18) for amplifying the output signal of the oscillator (18).

14. Use of the radar fill level measuring device (10) according to any of the preceding claims for determining a fill level of a medium.

15. Method for operating a radar fill level measuring device (10) according to any of the preceding claims 1 to 13, the method comprising the steps of:
generating, with the radar module (12) of the radar fill level measuring device (10), a transmission signal (11) which has a frequency of at least 60 GHz;
emitting, with the at least one antenna (14) of the radar fill level measuring device (10), the transmission signal (11) in the direction of a surface (15) of a medium;
receiving, with the at least one antenna (14) of the radar fill level measuring device (10), a received signal (13) reflected on the surface (15) of the medium;
mixing, with a frequency mixer (42) of the radar fill level measuring device (10), the transmission signal (11) with the received signal (13) to generate an intermediate frequency signal;
evaluating, with a digital control unit (50) of the radar fill level measuring device (10), a digital measuring signal correlating with the intermediate frequency signal by determining a distance of the radar fill level measuring device (10) to the surface of the medium and/or by determining a fill level of the medium.

## Revendications

1. Appareil de mesure du niveau de remplissage par radar (10) pour déterminer un niveau de remplissage d'un médium, le dispositif de mesure du niveau de remplissage par radar (10) comprenant :
un module radar (12) pour générer un signal d'émission (11) ayant une fréquence d'émission d'au moins 60 GHz ; et
au moins une antenne (14) couplée au module radar (12) pour transmettre le signal d'émission (11) à une surface (15) d'un médium et pour recevoir un signal reçu (13) réfléchi à la surface (15);
dans lequel le module radar (12) comprend:
- une boucle à verrouillage de phase (16) comprenant un oscillateur (18) pour délivrer un signal de sortie à une sortie (19, 21) de l'oscillateur (18), un détecteur de phase (20) et un diviseur de fréquence (26) couplé entre la sortie (19, 21) de l'oscillateur (18) et une entrée (23) du détecteur de phase (20) pour générer un signal divisé en fréquence basé sur le signal de sortie de l'oscillateur (18); et
- un émetteur-récepteur (40) couplé entre l'oscillateur (18) et l'antenne (14) pour séparer le signal d'émission (11) et le signal reçu (13),
dans lequel le signal de sortie de l'oscillateur (18) a une fréquence de sortie d'au moins 60 GHz;
dans lequel la sortie (19, 21) de l'oscillateur (18) est directement reliée à une entrée (41) de l'émetteur-récepteur (40), de sorte que, sur la base du signal de sortie de l'oscillateur (18), le signal d'émission (11) peut être rayonné par l'antenne (14);
dans lequel le diviseur de fréquence (26) et l'émetteur-récepteur (40) sont couplés à la même sortie (19, 21) de l'oscillateur (18);
le détecteur de phase (20) ayant une entrée de référence (27) pour recevoir un signal de fréquence de référence et une sortie de détecteur de phase (25) couplée à une entrée de commande (17) de l'oscillateur (18); et
dans lequel le détecteur de phase (20) est configuré pour déterminer une différence de phase entre le signal de fréquence de référence et le signal divisé en fréquence et pour délivrer à la sortie du détecteur de phase (25) un signal de commande en corrélation avec la différence de phase déterminée pour commander la fréquence de sortie du signal de sortie de l'oscillateur (18) vers l'entrée de commande (17) de l'oscillateur (18).

2. Appareil de mesure du niveau de remplissage par radar (10) selon la revendication 1,
dans lequel l'oscillateur (18) est un oscillateur d'onde fondamentale; et
dans lequel l'oscillateur (18) est configuré pour délivrer une fréquence fondamentale de l'oscillateur (18) à la sortie (19) de l'oscillateur (18) directement connectée à l'entrée (41) de l'émetteur-récepteur (40).

3. Appareil de mesure du niveau de remplissage par radar (10) selon la revendication 1,
dans lequel l'oscillateur (18) est un oscillateur push-push; et/ou
dans laquelle la sortie (21) de l'oscillateur (18) est une sortie haute fréquence (21) de l'oscillateur (18).

4. Appareil de mesure du niveau de remplissage par radar (10) selon la revendication 3,
dans lequel l'oscillateur (18) est configuré pour émettre une première harmonique à la sortie (21) de l'oscillateur directement connectée à l'entrée (41) de l'émetteur-récepteur (40) ; et/ou
dans lequel l'oscillateur (18) est configuré pour délivrer un signal de sortie à une fréquence double de la fréquence fondamentale de l'oscillateur (18) à la sortie (21) de l'oscillateur (18) directement connectée à l'entrée (41) de l'émetteur-récepteur (40).

5. Appareil de mesure du niveau de remplissage par radar (10) selon l'une quelconque des revendications précédentes,,
dans lequel le module radar (12) est conçu comme un module radar en bande V, un module radar en bande E, un module radar en bande W, un module radar en bande F, un module radar en bande D, un module radar en bande G, un module radar en bande Y et/ou un module radar en bande J.

6. Appareil de mesure du niveau de remplissage par radar (10) selon l'une quelconque des revendications précédentes,,
dans lequel la boucle à verrouillage de phase (16) comprend en outre un filtre de boucle (24) couplé entre la sortie du détecteur de phase (25) du détecteur de phase (20) et l'entrée de commande (17) de l'oscillateur (18) pour filtrer le signal de commande du détecteur de phase (20).

7. Appareil de mesure du niveau de remplissage par radar (10) selon l'une quelconque des revendications précédentes, comprenant en outre:
un mélangeur de fréquences (42) couplé à l'émetteur-récepteur (40) pour générer un signal de fréquence intermédiaire basé sur le signal d'émission (11) et basé sur le signal de réception (13).

8. Appareil de mesure du niveau de remplissage par radar (10) selon l'une quelconque des revendications précédentes, comprenant en outre :
une unité de commande numérique (50) pour contrôler la boucle à verrouillage de phase (16) et/ou pour contrôler le détecteur de phase (20) avec des signaux de commande numériques.

9. Appareil de mesure de niveau de remplissage par radar (10) selon la revendication 8,
dans lequel l'appareil de mesure du niveau de remplissage par radar (10) est configuré comme un radar à ondes continues modulées en fréquence (FMCW) ; et/ou
dans lequel l'appareil de mesure de niveau de remplisasge par radar (10) est configuré comme un radar à ondes continues à fréquence échelonnée (SFCW).

10. Appareil de mesure du niveau de remplissage par radar (10) selon l'une quelconque des revendications 8 ou 9,
dans lequel l'unité de commande numérique (50) est en outre configurée pour déterminer une distance à la surface du médium et/ou un niveau de remplissage du médium sur la base d'un signal de fréquence intermédiaire émis par un mélangeur de fréquences (42) de l'appareil de mesure du niveau de remplissage par radar.

11. Appareil de mesure du niveau de remplissage par radar (10) selon l'une quelconque des revendications précédentes, comprenant en outre:
un amplificateur (47) pour amplifier un signal de fréquence intermédiaire émis par un mélangeur de fréquences (42) de l'appareil de mesure du niveau de remplissage du radar; et/ou
un filtre (43) couplé entre une unité de commande numérique (50) et un mélangeur de fréquences (42) de l'appareil de mesure du niveau de remplissage par radar; et/ou
un convertisseur analogique-numérique (46) couplé entre une unité de commande numérique (50) et un mélangeur de fréquences (42) de l'appareil de mesure du niveau de remplissage par radar, dans lequel le convertisseur analogique-numérique (46) est configuré pour générer un signal de mesure numérique en corrélation avec un signal de fréquence intermédiaire délivré par le mélangeur de fréquences (42).

12. Appareil de mesure du niveau de remplissage par radar (10) selon l'une quelconque des revendications précédentes, comprenant en outre:
un oscillateur de référence (45) qui est couplé à l'entrée de référence (27) du détecteur de phase (20) et qui est configuré pour générer des signaux de fréquence de référence.

13. Appareil de mesure du niveau de remplissage par radar (10) selon l'une quelconque des revendications précédentes, comprenant en outre :
un amplificateur (51) couplé à la sortie (19, 21) de l'oscillateur (18) pour amplifier le signal de sortie de l'oscillateur (18).

14. Utilisation de l'appareil de mesure du niveau de remplissage par radar (10) selon l'une quelconque des revendications précédentes pour déterminer le niveau de remplissage d'un médium.

15. Procédé de fonctionnement d'un appareil de mesure du niveau de remplissage par radar (10) selon l'une quelconque des revendications précédentes 1 à 13, le procédé comprenant les étapes suivantes:
générer, avec le module radar (12) de l'appareil de mesure du niveau de remplissage par radar (10), d'un signal d'émission (11) ayant une fréquence d'au moins 60 GHz;
rayonner, avec au moins une antenne (14) de l'appareil de mesure du niveau de remplissage par radar (10), le signal d'émission (11) en direction d'une surface (15) d'un médium;
recevoir, avec au moins une antenne (14) de l'appareil de mesure du niveau de remplissage par radar (10), un signal reçu (13) réfléchi sur la surface (15) du médium;
mélanger, avec un mélangeur de fréquences (42) de l'appareil de mesure du niveau de remplissage par radar (10), le signal d'émission (11) avec le signal reçu (13) pour générer un signal de fréquence intermédiaire ;
évaluer, avec une unité de commande numérique (50) de l'appareil de mesure du niveau de remplissage par radar (10), un signal de mesure numérique en corrélation avec le signal de fréquence intermédiaire en déterminant une distance de l'appareil de mesure du niveau de remplissage par radar (10) par rapport à la surface du médium et/ou en déterminant un niveau de remplissage du médium.
